(19) Europäisches Patentamt
European Patent Office
Office européen des brevets

(11) **EP 2 143 181 B1**

(12) **FASCICULE DE BREVET EUROPEEN**

(45) Date de publication et mention
de la délivrance du brevet:
**20.10.2010 Bulletin 2010/42**

(51) Int Cl.:
***H01S 5/14*** (2006.01)

(21) Numéro de dépôt: **08736560.7**

(22) Date de dépôt: **24.04.2008**

(86) Numéro de dépôt international:
**PCT/EP2008/055033**

(87) Numéro de publication internationale:
**WO 2008/135404 (13.11.2008 Gazette 2008/46)**

(54) **SOURCE LASER COMPACTE A FAIBLE LARGEUR SPECTRALE**

KOMPAKTE LASERQUELLE MIT VERRINGERTER SPEKTRALER BREITE

COMPACT LASER SOURCE WITH REDUCED SPECTRAL WIDTH

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **27.04.2007 FR 0703099**

(43) Date de publication de la demande:
**13.01.2010 Bulletin 2010/02**

(73) Titulaires:
• **THALES**
  **92200 Neuilly-sur-Seine (FR)**
• **Centre National d'Etudes Spatiales**
  **75039 Paris Cedex 01 (FR)**
• **Observatoire de Paris**
  **75014 Paris (FR)**

(72) Inventeurs:
• **HOLLEVILLE, David**
  **F-75013 Paris (FR)**
• **PERRIN, Stéphanie**
  **F-91360 Villemoisson/Orge (FR)**
• **DIMARCQ, Noël**
  **F-91150 Etampes (FR)**
• **ESNAULT, François-Xavier**
  **F-75013 Paris (FR)**

(74) Mandataire: **Lucas, Laurent Jacques**
**Marks & Clerk France**
**Conseils en Propriété Industrielle**
**Immeuble " Visium "**
**22, avenue Aristide Briand**
**94117 Arcueil Cedex (FR)**

(56) Documents cités:
**EP-A- 1 172 906      EP-A- 1 265 324**
**US-A- 5 450 427      US-A- 5 627 848**

## Description

L'invention concerne une source laser compacte destinée à des applications nécessitant une faible largeur spectrale et une forte puissance.

Des telles sources laser sont utilisées dans des bancs optiques pour des applications telles que le refroidissement d'atomes par laser, les expériences d'interférométrie atomique, les capteurs inertiels, ou pour d'autres applications scientifiques.

Les diodes laser, désignées par l'acronyme DBR pour Distributed Bragg Reflector en langue anglaise, sont utilisées en tant que source laser dans de nombreuses applications. Elles comportent l'avantage d'être faciles à mettre en oeuvre. Par exemple, l'émission d'une diode DBR à 852nm peut s'effectuer sur une bande d'environ 4THz selon l'un des modes longitudinaux. Le fonctionnement est en général monomode obtenu facilement à une fréquence déterminée en fixant le courant de commande de la diode et en balayant la température de consigne.

Cependant les diodes laser présentent, dans un fonctionnement monomode à une fréquence désirée, une largeur de raie de l'ordre de 3 MHz incompatible avec les performances nécessaires pour de telles applications.

Pour diminuer la largeur spectrale, ou largeur de raie du monomode, le choix s'est alors orienté vers des sources laser réalisées à partir d'un montage de diode laser en cavité étendue rajoutant alors un paramètre supplémentaire, la longueur de la cavité.

En effet la largeur de la raie spectrale du monomode obtenue par une cavité optique varie de façon inverse à la longueur de cette cavité. Cette largeur de raie est exprimée par la relation suivante :

$$\Delta v_{LCE} = \Delta v_{Diode} \left[ L_{diode} / L_{LCE} \right]^2$$

$\Delta V_{LCE}$ étant la largeur de raie du monomode dans la cavité,

$\Delta V_{Diode}$ étant la largeur de raie du monomode fourni par la diode laser seule

$L_{Diode}$ étant la longueur du résonateur de la diode laser

$L_{LCE}$ étant la longueur de la cavité étendue.

L'augmentation de la longueur $L_{LCE}$ de la cavité étendue diminue la largeur de raie $\Delta V_{LCE}$ du monomode dans la cavité.

Néanmoins, l'utilisation d'une cavité plus longue pour diminuer la largeur de raie comporte l'inconvénient de donner des modes de résonance laser beaucoup plus proches en fréquence que lors de l'utilisation d'une diode laser seule. Un élément de sélection de mode dominant dans la cavité étendue devient indispensable.

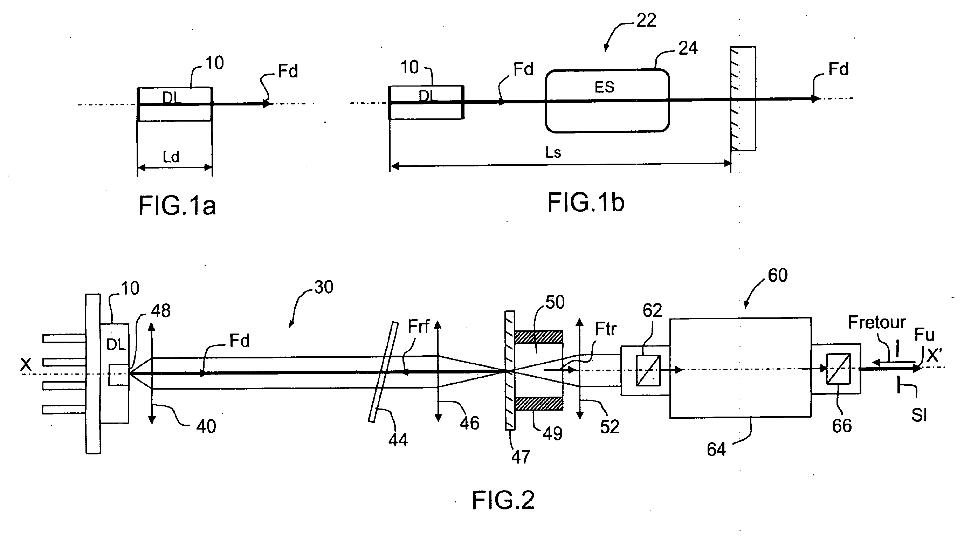

La figure 1a montre un synoptique d'une diode laser DL 10. La figure 1b montre une source laser 22 comportant la diode laser DL 10 de la figure 1 a montée en cavité étendue.

La diode laser DL 10 de la figure 1a de longueur Ld de résonateur de 1 millimètres fournit un faisceau laser Fd monomode de largeur spectrale 30MHz.

La source laser de la figure 1b comporte la diode laser DL 10 montée en cavité étendue générant des modes de largeur de raie bien moins larges de l'ordre de 100KHZ que celle de la diode seule. Un élément sélectif 24 en longueur d'onde λ est placé dans le chemin optique du faisceau laser Fd pour la sélection du mode principal de la cavité résonante. La longueur Ls de la source laser est de 60 millimètres.

Dans les sources laser de l'état de l'art, l'élément sélectif est réalisé à l'aide d'un réseau de diffraction (configuration Littrow ou Litmann) ou avec un filtre interférentiel, de très faible épaisseur, typiquement de 20 micromètres.

L'utilisation d'un filtre interférentiel plutôt qu'un réseau de diffraction permet de garantir une meilleure stabilité de la cavité étendue car un procédé d'auto alignement dans les deux directions traverses peut être mis en place.

La figure 2 montre un exemple de réalisation d'une source laser de l'état de l'art fournissant un faisceau laser monomode Fu avec une faible largeur de raie spectrale.

La source laser de la figure 2 comporte la diode laser DL 10, une cavité optique étendue 30 fournissant un chemin optique au faisceau laser Fd généré par la diode laser 10, une lentille de collimation d'entrée 40 du faisceau Fd en sortie de la diode laser DL 10.

Le faisceau Fd se propage dans la cavité 30 à travers une lame étalon 44 réalisant l'élément sélectif ES et une lentille de collimation de sortie 46 vers une lame réfléchissante de sortie 47 réfléchissant Frf une partie du faisceau incident Fd vers la diode laser 10 et transmettant Ftr l'autre partie du faisceau incident Fd vers l'extérieur de la cavité étendue 30 formant le faisceau laser utile Fu généré par la source.

La résonance optique dans la cavité s'effectue par les aller/retour du faisceau réfléchi entre deux surfaces réfléchissantes, la lame réfléchissante de sortie 47 et une lame réfléchissante 48 du résonateur de la diode laser 10.

Une cale piézoélectrique 49 comportant une ouverture 50 pour le passage du faisceau laser utile Fu, permet un réglage de la longueur de la cavité étendue.

La diode laser 10 est très sensible à un retour de lumière Fretour pouvant se produire par réflexion du faisceau utile Fu en sortie de la source laser. Pour éviter la perturbation de la diode laser DL par le faisceau de retour Fretour, la cavité étendue 30 comporte en sortie du faisceau après la lame réfléchissante de sortie 47, un isolateur optique 60 ayant pour fonction de bloquer le retour de lumière Fretour, par la sortie SI de la source laser.

Une lentille de collimation d'isolateur 52 assure la focalisation du faisceau en sortie de la cavité étendue sur l'isolateur optique 60.

De façon connue, l'isolateur optique 60 comporte, selon l'axe XX' de propagation du faisceau en sortie de la cavité étendue, un polariseur 62 laissant passer le faisceau en polarisation rectiligne avec un angle de polarisation du faisceau de 0 degré en sortie de la cavité 30.

Un rotateur de Faraday 64 produit une rotation de la polarisation du faisceau en sortie du polariseur 62 de + 45 degrés. Le faisceau en sortie du rotateur de Faraday 64 passe dans un séparateur de polarisation 66 incliné de +45 degrés et transmet le faisceau laser utile Fu vers la sortie SI de la source laser avec la polarisation de 45 degrés.

En cas de retour de lumière Fretour par la sortie Sr de la source laser vers la diode laser DL, par réflexion du faisceau utile Fu, le rotateur de polarisation 66 tourne la polarisation de la lumière réfléchie Fretour à nouveau de +45 degrés. C'est une propriété du rotateur de Faraday de tourner la polarisation dans le même sens quel que soit le sens du faisceau lumineux dans le rotateur.

La lumière réfléchie Fretour arrive sur le polariseur 62 avec une polarisation de 90 degrés qui se trouve alors bloquée par le polariseur 62, empêchant un retour sur la diode laser DL.

La perte d'intensité lumineuse d'une telle source est importante de l'ordre de 50% par rapport à l'intensité du faisceau en sortie de la diode laser DL 10.

Dans le cas d'utilisation d'un polariseur 62 à réflexion, la lumière de retour Fretour est réfléchie dans une direction perpendiculaire au faisceau utile évitant de la même façon son retour vers la diode laser DL.

Un principal inconvénient d'une telle source laser à cavité étendue avec isolateur 60 de retour de lumière Fretour vers la diode laser, est l'encombrement. Ces sources sont difficilement transportables et handicapent le développement de dispositifs optiques destinés à être embarqués dans des mobiles ou des satellites pour des applications spatiales.

Il est utile de rappeler que les caractéristiques importantes demandées aux sources laser sont, pour les bancs de refroidissement des atomes une largeur de raie du faisceau laser inférieur au 1MHz avec une puissance de l'ordre de 100milliwats; pour des bancs de détection des atomes, une largeur de raie du faisceau laser inférieure à 100KHz avec une puissance de l'ordre de 5milliwats.

Dans le cas de réalisation d'un banc optique compact utilisable pour le refroidissement des atomes et la détection les caractéristiques des sources laser nécessaires sont plus difficiles à obtenir, en effet, il faut une largeur de raie du faisceau laser inférieure à 100KHz avec une puissance de l'ordre de 100milliwats.

La demande de brevet EP 1 172 906 A décrit une source laser telle que définie dans le préambule de la revendication 1.

Afin de pallier les inconvénients des sources laser de l'état de l'art, l'invention propose une source laser à cavité externe générant un faisceau laser utile comportant au moins une diode laser DL montée dans une cavité optique étendue délimité entre deux surfaces réfléchissantes fournissant un chemin optique à un faisceau laser Fd généré par la diode laser DL, un filtre sélecteur de mode dans le chemin optique de la cavité pour sélectionner un mode de résonance parmi un peigne de modes de résonance du faisceau laser dans la cavité.

La cavité étendue comporte dans son chemin optique un dispositif optique comportant, un polariseur laissant passer 100% d'une polarisation rectiligne du faisceau Fd généré par la diode laser, d'angle de polarisation de référence $\theta_0$ égal à 0 degré, un rotateur de polarisation du faisceau en sortie du polariseur d'un angle de rotation prédéterminé $\theta_1$, un séparateur de polarisation du faisceau en sortie du rotateur de polarisation, le séparateur de polarisation étant incliné dans la cavité de façon que son axe de transmission soit orienté selon un angle $-\theta_1$ de signe opposé et de même valeur que l'angle de polarisation du faisceau en sortie du rotateur, le dispositif optique empêchant un retour d'un faisceau de réflexion du faisceau utile vers la diode laser DL.

Avantageusement le séparateur de polarisation sépare le faisceau en sortie du rotateur de polarisation en un faisceau réfléchi selon son axe de réflexion formant le faisceau laser utile et en un faisceau transmis, selon un axe de transmission perpendiculaire à l'axe de réflexion, destiné à être réfléchi par une des deux surfaces réfléchissantes de la cavité étendue vers la diode laser DL,

Dans une réalisation, l'angle de rotation $\theta_1$ de la polarisation du faisceau en sortie rotateur ainsi que l'angle de l'axe de transmission $-\theta_1$ du séparateur de polarisation sont déterminés en fonction des intensités souhaitées des faisceaux transmis It et réfléchie Ir par le séparateur de polarisation, ces intensités étant définies par :

$$It = \cos^2(2.\,\theta_1)$$

$$Ir = \sin^2(2.\,\theta_1)$$

Dans une autre réalisation de la source laser selon l'invention; l'angle de rotation $\theta_1$ de polarisation du faisceau en sortie du rotateur de polarisation est choisi de valeur +28 degrés, l'axe de transmission du séparateur de polarisation étant, dans ce cas, orienté de -28 degrés et l'axe de réflexion de $90-\theta_1$. soit +62 degrés

Dans une autre réalisation, le filtre sélecteur de mode est un filtre interférentiel.

Dans la source laser à cavité externe selon l'invention, le dispositif optique est configuré de façon que, d'une part, le faisceau réfléchi par une des deux surfaces réfléchissantes de la cavité vers la diode laser DL à travers le dispositif optique ait la même polarisation à 0 degré que celle du faisceau en sortie de la diode laser DL pour créer la résonance dans la cavité étendue et que, d'autre part, le faisceau réfléchi du faisceau utile revenant par la sortie SI de la source à travers le séparateur de polarisation et le rotateur de polarisation ait une polarisation perpendiculaire à la polarisation du faisceau en sortie du polariseur, le polariseur empêchant le faisceau réfléchi de retourner vers la diode laser DL.

Un principal objectif de cette invention est de réaliser une source laser compacte de faible encombrement tout en obtenant des bonnes performances spectrales du faisceau monomode et fournissant une puissance laser importante.

Un autre objectif est de réaliser une source laser fiable avec un coût de fabrication plus faible que celui des sources actuelles.

L'invention sera mieux comprise par la description d'un exemple de réalisation d'une source laser selon l'invention à l'aide de dessins indexés dans lesquels :

-    la figure 1a, déjà décrite, montre un synoptique d'une diode laser DL;
-    la figure 1b, déjà décrite, montre une source laser comportant la diode laser DL de la figure 1a montée en cavité étendue;
-    la figure 2, déjà décrite, montre un exemple de réalisation d'une source laser de l'état de l'art fournissant un faisceau laser monomode ;
-    la figure 3 montre une source laser en cavité étendue selon l'invention ;
-    les figures 4a et 4b montrent la polarisation des différents faisceaux laser dans la cavité étendue de la figure 3 et ;
-    les figures 5a et 5b montrent une réalisation physique de la source laser compacte selon l'invention.

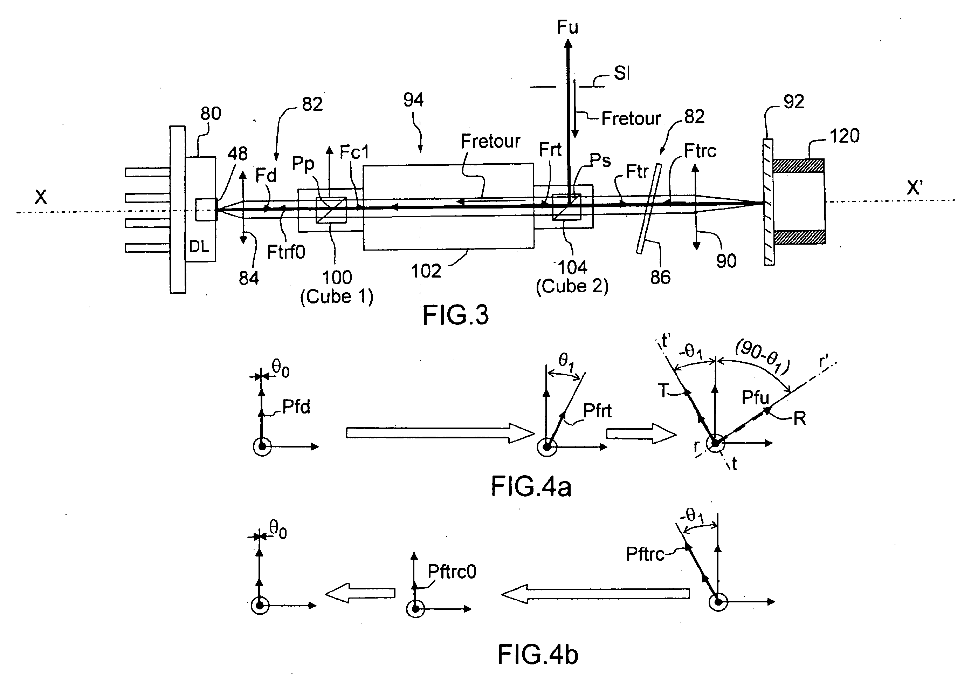

La figure 3 montre une source laser en cavité étendue selon l'invention.

La source de la figure 3 comporte selon un axe principal XX' de propagation du faisceau laser Fd dans la cavité :

-    une diode laser DL 80 montée dans une cavité étendue 82 fournissant un chemin optique à un faisceau laser Fd de polarisation rectiligne, d'angle de polarisation de référence $\theta_0$ égal à 0 degré, génère par la diode laser. La cavité étendue 82 est, dans cette réalisation, délimitée entre deux surfaces réfléchissantes, un miroir 92 placé à une extrémité de la cavité, formant une première surface réfléchissante de la cavité et une lame réfléchissante 48 du résonateur de la diode laser DL tel que représentée aux figures 1 a et 1b à l'autre extrémité de la cavité étendue 82 formant une deuxième surface réfléchissante.

-    une lentille de collimation d'entrée 84 du faisceau laser Fd dans la cavité,
-    une lame étalon 86 pour sélectionner un mode de résonance dans -la cavité étendue,
-    une lentille de sortie oeil de chat 90 focalisant le faisceau laser sur le miroir 92 de la cavité et,
-    selon une principale caractéristique de l'invention, un dispositif optique 94 comportant, entre la lentille de collimation d'entrée 84 et la lame étalon 86 (filtre sélecteur de mode 86) :
-    un polariseur 100 laissant passer 100% d'une polarisation rectiligne d'angle de polarisation $\theta_0$ égal à 0 degré du faisceau Fd généré par la diode laser,
-    un rotateur de polarisation 102 configuré pour produire une rotation de la polarisation du faisceau Fc1 en sortie du polariseur 100 d'un angle de rotation $\theta_1$, soit Pfrt cette polarisation,
-    un séparateur de polarisation 104 séparant le faisceau Frt en sortie du rotateur de polarisation 102 en un faisceau réfléchi R (voir figure 4a) selon

un axe de réflexion rr' formant le faisceau laser utile Fu et en un faisceau transmis T, selon un axe de transmission tt' perpendiculaire à l'axe de réflexion rr'.

Le séparateur de polarisation 104 est incliné par rapport à l'axe XX' de la cavité étendue 82 de façon que son axe de transmission tt' soit orienté selon un angle -$\theta_1$ de signe opposé et de même valeur que l'angle de rotation de polarisation $\theta_1$ en sortie du rotateur 104, son axe de réflexion rr' étant orienté de l'angle complémentaire (90-$\theta_1$) à 90 degrés.

Le faisceau transmis Ftr dans le chemin optique de la cavité est destiné à être réfléchi vers la diode laser DL par le miroir 92 de la cavité formant des résonances optiques dans la cavité étendue entre le miroir 92 dans la cavité étendue et la lame réfléchissante 48 du résonateur de la diode laser DL.

La sortie du faisceau utile Fu de la source laser, selon l'invention, s'effectue, contrairement aux source de l'état de l'art, de façon latérale selon un axe YY' perpendiculaire à l'axe XX' du chemin optique du faisceau Fd généré par la diode laser DL dans la cavité.

Dans cette réalisation, selon l'invention, le dispositif optique 94 est configuré pour que, d'une part, :

-    le faisceau réfléchi par le miroir 92 de la cavité vers la diode laser DL passant à travers le séparateur de polarisation 104 incliné et le rotateur 102 qui produit à nouveau une même rotation du faisceau réfléchi de θ, ait la même polarisation à 0 degré que celle du faisceau Fd en sortie de la diode laser DL pour créer la résonance par les aller/retour du faisceau entre le miroir 92 de la cavité et la lame réfléchissante 48 de la diode laser DL et que, d'autre part, :
-    le faisceau réfléchi Fretour du faisceau utile Fu revenant par la sortie SI à travers le séparateur de polarisation 104 et le rotateur de polarisation 102 ait une polarisation perpendiculaire à la polarisation du faisceau Fc1 en sortie du polariseur 100. Le polariseur 100 empêche le faisceau réfléchi Fretour de retourner vers la diode laser DL.

Dans une réalisation préférentielle, l'angle de rotation de polarisation $\theta_1$ du faisceau Frt en sortie du rotateur de polarisation 102 est choisi de valeur +28 degrés. Dans ce cas l'axe de transmission tt' du séparateur de polarisation 104 est orienté de -28 degrés et l'axe de réflexion rr' de $90-\theta_1$, soit +62 degrés.

Le faisceau réfléchi R est le faisceau utile Fu sortant latéralement de la cavité par une sortie SI. Le faisceau transmis T selon la direction principale de la cavité après passage par la lame étalon 86 et la lentille 90 oeit de chat est réfléchi par le miroir 92 vers la diode laser DL.

Dans une réalisation le polariseur 100 est un cube 1 par exemple de type présentant un plan de séparation Pp de polarisation. Seule la polarisation à 0 degré sera transmise par le faisceau laser Fd généré par la diode laser DL dans le chemin optique de la cavité. Le séparateur de polarisation 104 est un autre cube 2 comportant un plan Ps de séparation de polarisation.

Le rotateur de polarisation 102 est un rotateur de Faraday. Dans ce type de rotateur la rotation de polarisation est fonction de l'intensité d'un champ magnétique appliqué au rotateur.

Dans une réalisation de la source selon l'invention, le polariseur 100 est un polariseur de type à obstruction bloquant le faisceau de retour Fretour.

Dans une autre réalisation de la source selon l'invention, le polariseur 100 est un polariseur de type à réflexion réfléchissant le faisceau de retour Fretour perpendiculairement à l'axe de transmission empêchant la lumière Fretour de passer vers la diode laser DL

Par la suite est décrit le fonctionnement de la source laser selon l'invention.

Les figures 4a et 4b montrent la polarisation des différents faisceaux laser dans la cavité étendue de la figure 3.

La diode laser DL est configurée pour fournir un faisceau laser Fd de polarisation rectiligne Pfd d'angle de polarisation de référence $\theta_0$ égal à 0 degré, représenté à la figure 4a

Le cube 1 (polariseur 100) est orienté pour transmettre, selon l'axe XX' de la cavité un faisceau Fc1 avec100% de cette polarisation à 0 degré, réfléchissant perpendiculairement à l'axe XX' du chemin optique de la cavité toute partie du faisceau n'ayant pas la même polarisation.

Le faisceau Fc1 avec une polarisation à 0 degré en sortie du cube 1 passe dans le rotateur de polarisation 102 produisant une rotation de sa polarisation de + 28 degrés. La figure 4a montre la polarisation Pfrt du faisceau Frt à +28degrès en sortie du rotateur 102.

Le faisceau Frt en sortie du rotateur 102 passe dans le cube 2 dont l'axe de transmission Test orienté à -28 degrés et l'axe de réflexion R à +62 degrés.

Le faisceau réfléchi Fu par le cube 2, de polarisation Pfu à +62degrès, forme le faisceau utile Fu en sortie SI de la cavité, le faisceau transmis Ftr par le cube 2 (séparateur de polarisation 104) est réfléchi par le miroir 92 de cavité après passage par la lame étalon 86 et la lentille de focalisation oeil de chat 90 sur le miroir 92 de cavité.

L'intensité lumineuse It du faisceau réfléchi Fu sera donc exprimée par la relation :

$$It = \cos^2(2.\,\theta_1)$$

et l'intensité lumineuse Ir du faisceau transmis Ftr sera donc exprimée par la relation :

$$Ir = \sin^2(2.\,\theta_1)$$

Dans cette réalisation avec $\theta_1$ =+28 degrés, l'intensité transmise It par le cube 2 sera de 30% de l'intensité du faisceau Frt arrivant sur le cube 2 et l'intensité réfléchie Ir de 70%. La puissance du faisceau utile Fu représente 70% du faisceau généré par la diode laser DL ce qui est bien supérieur au rendement des sources laser de l'état de l'art utilisant la même diode laser DL.

Considérons le faisceau transmis Ftr vers le miroir 92 de la cavité étendue. Le faisceau transmis Ftr, de polarisation -28 degrés est réfléchi par le miroir 92 de cavité à travers la lentille oeil de chat 90 et la lame étalon 86 formant un faisceau réfléchi dans la cavité Ftrc. Le faisceau réfléchi Ftrc repasse par le cube 2 et le rotateur de Faraday 102. La polarisation Pftrc du faisceau réfléchi Ftrc dans la cavité est tournée de +28 par le rotateur de polarisation 102 qui se trouve avec une polarisation Pftrc0 à 0 degré (voir figure 4b). Le faisceau réfléchi dans la cavité est transmis par le cube 1, faisceau Ftrf0 qui revient jusqu'à la diode laser DL avec la même polarisation à 0 degré.

Considérons maintenant un faisceau de retour Fretour résultant d'une réflexion du faisceau utile Fu avec la même polarisation entrant par la sortie SI de la cavité :

Le faisceau de retour Fretour, réfléchi par le cube 2 vers la diode laser DL sur le chemin optique de la cavité selon l'axe XX', passe dans le rotateur 102 faisant tourner sa polarisation de +28 degrés.

En sortie du rotateur de polarisation 102 la polarisation du faisceau de retour Fretour sera sa polarisation initiale de +62 (polarisation du faisceau utile Fu) augmentée de la rotation de polarisation dans le rotateur 102 soit +62+28 degrés soit 90 degrés. Le cube 1 (polariseur) 100 réfléchi ce faisceau de retour perpendiculairement au chemin optique XX' de la cavité empêchant son passage vers la diode laser DL.

Le dispositif optique 94 dans la cavité étendue se comporte comme un circulateur permettant le passage des faisceaux en multiples allers/retours (Fd, Ftrc) dans le chemin optique de la cavité en résonance mais isolant les faisceaux de retour Fretour revenant par la sortie SI de la cavité évitant ainsi de perturber la diode laser DL.

Dans une autre réalisation de la source laser selon l'invention, une cale piézoélectrique 120 pour la modulation de position du miroir 92 dans la cavité étendue peut être réalisée à partir d'un cube ou un cylindre massif comportant une face réfléchissante. Cette face réfléchissante faisant office de miroir 92 peut être réalisée par une métallisation d'une des faces de la cale piézoélectrique destinée à la réflexion du faisceau laser dans la cavité.

En effet, contrairement aux sources de l'état de l'art, la cale piézoélectrique 120 n'a plus besoin de comporter un passage 50 (voir figure 2) pour le faisceau utile Fu sortant de la cavité. Une cale piézoélectrique avec une fréquence de résonance élevée (typique de 300 kHz) peut alors être utilisée et permet un asservissement sur une bande de fréquence importante.

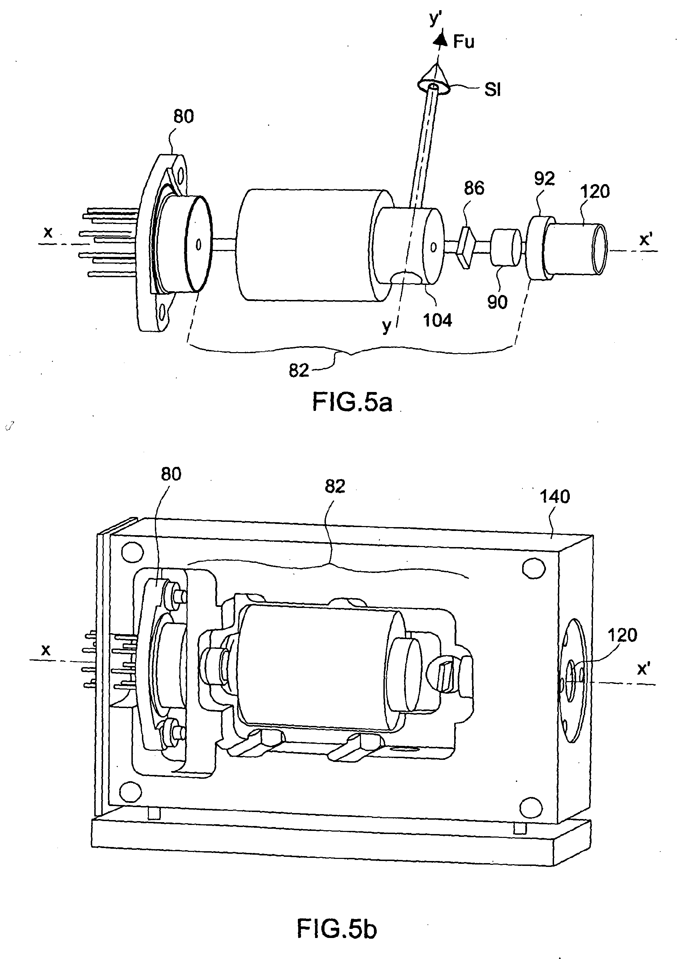

Les figures 5a et 5b montrent une réalisation physique de la source laser compacte selon l'invention.

La figure 5a montre les éléments optiques de la source selon l'invention et la figure 5b les éléments optiques montés dans un support mécanique.

La figure 5a montre, alignés selon l'axe du chemin optique XX' de la cavité étendue 82, la diode laser DL. La cavité étendue 82 comporte le dispositif optique 94 (non visible sur la figure 5a) le séparateur de polarisation 104 du dispositif optique 94, la lame étalon 86, la lentille de focalisation oeil de chat 90 et la cale piézoélectrique 120 avec son miroir 92.

La figure 5b montre les différents éléments optiques de la source selon l'invention montés dans un support mécanique 140 assurant un positionnement des éléments optiques. Le support mécanique 140 comporte une ouverture de sortie SI pour le faisceau laser utile Fu.

Le faisceau laser utile Fu sort par la sortie SI selon une direction YY' perpendiculaire à l'axe XX' de la cavité étendue.

La source laser selon l'invention comporte de nombreux avantages par rapport aux sources laser en cavité étendue de l'état l'art et notamment :

- un gain de place pour des puretés spectrales de même niveau par l'intégration dans la cavité étendue du dispositif optique 94 isolant la diode laser des faisceaux de retour,
- une largeur de raie plus faible pour un encombrement de la source réduit,
- un gain de puissance du faisceau laser utile Fu,
- pour une même puissance fournie par la source, une diode laser moins sollicité et donc une source plus fiable,
- une réalisation plus simple du fait que la cale piézoélectrique ne dois pas être traversée par le faisceau utile en sortie de la cavité.

La réalisation décrite n'est pas restrictive. D'autres réalisations sont possibles par l'utilisation d'éléments optiques réalisant les fonctions optiques décrites.

La valeur de l'angle de rotation $\theta_1$ du rotateur 102 et donc l'inclinaison de l'axe $-\theta_1$ de transmission du séparateur de polarisation 104 peut être choisie en fonction de la puissance réfléchie souhaitée par le séparateur de polarisation et donc la puissance utile Pu en sortie de la source laser.

## Revendications

1. Source laser à cavité externe générant un faisceau laser utile (Fu) comportant au moins une diode laser DL (10) montée dans une cavité optique étendue (30, 82) délimité entre deux surfaces réfléchissantes (92, 48) fournissant un chemin optique à un faisceau laser Fd généré par la diode laser DL, un filtre sélecteur de mode (44, 86) dans le chemin optique de la cavité pour sélectionner un mode de résonance parmi un peigne de modes de résonance du faisceau laser dans la cavité,

   un rotateur de polarisation (102) et un séparateur de polarisation (104)

   **caractérisé en ce que** la cavité étendue (82) comporte dans son chemin optique un dispositif optique (94) comportant, un polariseur (100) laissant passer 100% d'une polarisation rectiligne du faisceau Fd généré par la diode laser, d'angle de polarisation de référence égal à 0 degré, le rotateur de polarisation (102) du faisceau en sortie du polariseur (Fc1) d'un angle de rotation prédéterminé $\theta_1$, le séparateur de polarisation (104) du faisceau (Frt) en sortie du rotateur de polarisation, le séparateur de polarisation étant incliné dans la cavité de façon que son axe de transmission (tt') soit orienté selon un angle $(-\theta_1)$ de signe opposé et de même valeur que l'angle de polarisation du faisceau (Frt) en sortie du rotateur (102), le dispositif optique empêchant un retour d'un faisceau de réflexion (Fretour) du faisceau utile (Fu) vers la diode laser DL.

2. Source laser à cavité externe selon la revendication 1, **caractérisé en ce que** le séparateur de polarisation (104) sépare le faisceau (Frt) en sortie du rotateur de polarisation (102) en un faisceau réfléchi selon son axe de réflexion (rr') formant le faisceau laser utile (Fu) et en un faisceau transmis (Ftr), selon un axe de transmission (tt') perpendiculaire à l'axe de réflexion (rr'), destiné à être réfléchi par une des deux surfaces réfléchissantes (92) de la cavité étendue vers la diode laser DL,

3. Source laser à cavité externe selon la revendication 1 ou 2, **caractérisé en ce que** le dispositif optique (94) est configuré de façon que, d'une part, le faisceau réfléchi par une des deux surfaces réfléchissantes (92) de la cavité vers la diode laser DL à travers le dispositif optique (94) ait la même polarisation à 0 degré que celle du faisceau (Fd) en sortie de la diode laser DL pour créer la résonance dans la cavité étendue et que, d'autre part, le faisceau réfléchi (Fretour) du faisceau utile (Fu) revenant par la sortie SI de la source à travers le séparateur de polarisation (104) et le rotateur de polarisation (102) ait une polarisation perpendiculaire à la polarisation du faisceau (Fc1) en sortie du polariseur (100), le polariseur (100) empêchant le faisceau réfléchi (Fretour) de retourner vers la diode laser DL.

**4.** Source laser à cavité externe selon l'une revendications 1 ou 3, **caractérisée en ce qu'**elle comporte selon un axe principal XX' de propagation du faisceau laser dans la cavité :

   - une diode laser DL (80) montée dans une cavité étendue (82) fournissant un chemin optique à un faisceau laser (Fd) de polarisation rectiligne, d'angle de polarisation de référence $\theta_0$ égal à 0 degré, génère par la diode laser, la cavité étendue (82) étant délimitée entre deux surfaces réfléchissantes, un miroir (92) placé à une extrémité de la cavité, formant une première surface réfléchissante de la cavité et une lame réfléchissante (48) du résonateur de la diode laser DL à l'autre extrémité de la cavité étendue (82) formant une deuxième surface réfléchissante,
   - une lentille de collimation d'entrée (84) du faisceau laser (Fd) dans la cavité,
   - une lame étalon (86) pour sélectionner un mode de résonance dans la cavité étendue,
   - une lentille de sortie oeil de chat (90), focalisant le faisceau laser sur le miroir (92) de la cavité et,
   - le dispositif optique (94), entre la lentille de collimation d'entrée (84) et la lame étalon (86) (filtre sélecteur de mode).

**5.** Source laser à cavité externe selon l'une revendications 1 ou 4, **caractérisée en ce que** l'angle de rotation ($\theta_1$) de la polarisation du faisceau (Frt) en sortie rotateur (102) ainsi que l'angle de l'axe de transmission ($-\theta_1$) du séparateur de polarisation (104) sont déterminés en fonction des intensités souhaitées des faisceaux transmis It et réfléchie Ir par le séparateur de polarisation (104), ces intensités étant définies par :

$$It = \cos^2(2.\,\theta_1)$$

$$Ir = \sin^2(2.\,\theta_1)$$

**6.** Source laser à cavité externe selon l'une des revendications 1 à 5, **caractérisée en ce que** l'angle de rotation ($\theta_1$) de polarisation du faisceau (Frt) en sortie du rotateur de polarisation (102) est choisi de valeur +28 degrés, l'axe de transmission (tt') du séparateur de polarisation (104) étant, dans ce cas, orienté de -28 degrés et l'axe de réflexion (rr') de 90-$\theta_1$, soit +62 degrés.

**7.** Source laser à cavité externe selon l'une des revendications 1 à 6, **caractérisée en ce que** le rotateur (102) est un rotateur de Faraday.

**8.** Source laser à cavité externe selon l'une des revendications 1 à 7, **caractérisée en ce que** le filtre sélecteur de mode (86) est un filtre interférentiel.

**9.** Source laser à cavité externe selon l'une des revendications 1 à 8, **caractérisée en ce qu'**elle comporte une cale piézoélectrique (120) pour la modulation de position du miroir (92) dans la cavité étendue réalisée à partir d'un cube ou un cylindre massif comportant une face réfléchissante.

**10.** Source laser à cavité externe selon la revendication 9, **caractérisé en ce que** la face réfléchissante faisant office de miroir (92) est réalisée par une métallisation d'une des faces de la cale piézoélectrique destinée à la réflexion du faisceau laser dans la cavité.

**Claims**

**1.** An external cavity laser source generating a useful laser beam (Fu) including at least one laser diode DL (10) mounted in an extended optical cavity (30, 82) located between two reflecting surfaces (92, 48) providing an optical path for a laser beam Fd generated by the laser diode DL, a mode selection filter (44, 86) in the optical path of the cavity for selecting a resonance mode from a comb of resonance modes of the laser beam in the cavity, a polarisation rotator (102) and a polarisation separator (104),

   **characterised in that** the extended cavity (82) includes an optical device (94) in its optical path, which optical device comprises, a polariser (100) allowing passage of 100% of a rectilinear polarisation of the beam Fd generated by the laser diode, with a reference polarisation angle $\theta_0$ equal to 0 degrees, the polarisation rotator (102) of the beam at the output of the polariser (Fc1) having a predetermined angle of rotation $\theta_1$, the polarisation separator (104) of the beam (Frt) at the output of the polarisation rotator being inclined in the cavity so that its transmission axis (tt') is oriented at an angle ($-\theta_1$) having an opposing sign and the same value as the polarisation angle of the beam (Frt) at the output of the rotator (102), the optical device preventing feedback from a reflection beam (Fretour) of the useful beam (Fu) towards the laser diode DL.

2. The external cavity laser source according to claim 1, **characterised in that** the polarisation separator (104) separates the beam (Frt) at the output of the polarisation rotator (102) into a beam reflected along its reflection axis (rr') forming the useful laser beam (Fu) and into a beam (Ftr) transmitted along a transmission axis (tt') perpendicular to the axis of reflection (rr'), designed to be reflected by one of the two reflecting surfaces (92) of the extended cavity towards the laser diode DL.

3. The external cavity laser source according to claim 1 or 2, **characterised in that** the optical device (94) is configured so that, on the one hand, the beam reflected by one of the two reflecting surfaces (92) of the cavity towards the laser diode DL through the optical device (94) has the same polarisation at 0 degrees as the beam (Fd) at the output of the laser diode DL, so as to create the resonance in the extended cavity, and **in that**, on the other hand, the reflected beam (Fretour) of the useful beam (Fu) returning via the output SI of the source, through the polarisation separator (104) and the polarisation rotator (102), has a polarisation perpendicular to the polarisation of the beam (Fc1) at the output of the polariser (100), the polariser (100) preventing the reflected beam (Fretour) from returning towards the laser diode DL.

4. The external cavity laser source according to claim 1 or 3, **characterised in that** it includes the following along a principal axis XX' of propagation of the laser beam in the cavity:

   - a laser diode DL (80) mounted in an extended cavity (82) providing an optical path for a rectilinear polarisation laser beam (Fd), with a reference polarisation angle $\theta_0$ equal to 0 degrees, generated by the laser diode, the extended cavity (82) being located between two reflecting surfaces, a mirror (92) placed at one end of the cavity, which mirror forms a first reflecting surface in the cavity, and a reflecting plate (48) on the resonator of the laser diode DL at the other end of the extended cavity (82), which reflecting plate forms a second reflecting surface,
   - an input collimating lens (84) of the laser beam (Fd) in the cavity;
   - an etalon plate (86) for selecting a resonance mode in the extended cavity;
   - a cat eye output lens (90) focussing the laser beam onto the mirror (92) in the cavity and,
   - the optical device (94) between the input collimating lens (84) and the etalon plate (86) (mode selection filter).

5. The external cavity laser source according to any one of claims 1 to 4, **characterised in that** the angle of rotation ($\theta_1$) of the polarisation of the beam (Frt) at the output of the rotator (102), as well as the angle of the transmission axis (-$\theta_1$) of the polarisation separator (104), are determined as a function of the desired intensities of the transmitted beams It and the reflected beams Ir, by the polarisation separator (104), these intensities being defined by:

$$It = \cos^2 (2.\theta_1)$$

$$Ir = \sin^2 (2.\theta_1).$$

6. The external cavity laser source according to any one of claims 1 to 5, **characterised in that** the angle of rotation ($\theta_1$) of the polarisation of the beam (Frt) at the output of the polarisation rotator (102) is selected at a value of +28 degrees, the transmission axis (tt') of the polarisation separator (104) being in this case oriented at -28 degrees and the axis of reflection (rr') by 90-$\theta_1$, that is +62 degrees.

7. The external cavity laser source according to any one of claims 1 to 6, **characterised in that** the rotator (102) is a Faraday rotator.

8. The external cavity laser source according to any one of claims 1 to 7, **characterised in that** the mode selection filter (86) is an interferential filter.

9. The external cavity laser source according to any one of claims 1 to 8, **characterised in that** it includes a piezoelectric block (120) for modulating the position of the mirror (92) in the extended cavity which is produced from a solid cube or cylinder with a reflecting surface.

10. The external cavity laser source according to claim 9, **characterised in that** the reflecting surface used as a mirror (92) is produced by metallisation of one of the surfaces of the piezoelectric block designed for reflecting the laser beam in the cavity.

**Patentansprüche**

1. Laserquelle mit externem Resonator, die einen nützlichen Laserstrahl (Fu) erzeugt und Folgendes umfasst: wenigstens eine Laserdiode DL (10), die in einem erweiterten optischen Hohlraum (30, 82) montiert ist, der sich zwischen zwei reflektierenden Flächen (92, 48) befindet, die einen optischen Pfad für einen von der Laserdiode DL erzeugten Laserstrahl Fd bilden, ein Modenauswahlfilter (44, 86) in dem optischen Pfad des Hohlraums zum Auswählen einer Resonanzmode aus einem Resonanzmodenkamm des Laserstrahls in dem Hohlraum, einen Polarisationsrotator (102) und einen Polarisationsseparator (104),

**dadurch gekennzeichnet, dass** der erweiterte Hohlraum (82) in seinem optischen Pfad eine optische Vorrichtung (94) aufweist, die Folgendes umfasst: einen Polarisator (100), der 100% einer geradlinigen Polarisation des von der Laserdiode erzeugten Strahls Fd durchlässt, mit einem Referenzpolarisationswinkel $\theta_0$ gleich 0 Grad, wobei der Polarisationsrotator (102) des Strahls am Ausgang des Polarisators (Fc1) einen vorbestimmten Rotationswinkel $\theta_1$ hat, wobei der Polarisationsseparator (104) des Strahls (Frt) am Ausgang des Polarisationsrotators in dem Hohlraum so geneigt ist, dass seine Transmissionsachse (tt') in einem Winkel (-$\theta_1$) mit dem entgegengesetzten Vorzeichen und demselben Wert geneigt ist wie der Polarisationswinkel des Strahls (Frt) am Ausgang des Rotators (102), wobei die optische Vorrichtung eine Rückkehr eines Reflexionsstrahls (Fretour) des nützlichen Strahls (Fu) zur Laserdiode DL verhindert.

2. Laserquelle mit externem Resonator nach Anspruch 1, **dadurch gekennzeichnet, dass** der Polarisationsseparator (104) den Strahl (Frt) am Ausgang des Polarisationsrotators (102) in einen entlang seiner den nützlichen Laserstrahl (Fu) bildenden Reflexionsachse (rr') reflektierten Strahl und in einen entlang einer Transmissionsachse (tt') lotrecht zur Reflexionsachse (rr') transmittierten Strahl (Ftr) spaltet, der dazu bestimmt ist, von einer der beiden reflektierenden Flächen (92) des erweiterten Hohlraums zur Laserdiode DL reflektiert zu werden.

3. Laserquelle mit externem Resonator nach Anspruch 1 oder 2, **dadurch gekennzeichnet, dass** die optische Vorrichtung (94) so konfiguriert ist, dass einerseits der von einer der beiden reflektierenden Flächen (92) des Hohlraums zur Laserdiode DL durch die optische Vorrichtung (94) reflektierte Strahl dieselbe Polarisation bei 0 Grad hat wie der Strahl (Fd) am Ausgang der Laserdiode DL, um die Resonanz in dem erweiterten Hohlraum zu erzeugen, und **dadurch**, dass andererseits der reflektierte Strahl (Fretour) des über den Ausgang SI der Quelle durch den Polarisationsseparator (104) und den Polarisationsrotator (102) zurückkehrenden nützlichen Strahls (Fu) eine Polarisation lotrecht zur Polarisation des Strahls (Fc1) am Ausgang des Polarisators (100) hat, wobei der Polarisator (100) eine Rückkehr des reflektierten Strahls (Fretour) zur Laserdiode DL verhindert.

4. Laserquelle mit externem Resonator nach Anspruch 1 oder 3, **dadurch gekennzeichnet, dass** sie entlang einer Hauptachse XX' der Ausbreitung des Laserstrahls in dem Hohlraum Folgendes beinhaltet:

- eine Laserdiode DL (80), die in einem erweiterten Hohlraum (82) montiert ist, der einen optischen Pfad für einen Laserstrahl (Fd) mit geradliniger Polarisation bildet, mit einem Referenzpolarisationswinkel $\theta_0$ von gleich 0 Grad, erzeugt durch die Laserdiode, wobei der erweiterte Hohlraum (82) zwischen zwei reflektierenden Flächen begrenzt wird, wobei ein Spiegel (92) an einem Ende des Hohlraums positioniert ist, der eine erste reflektierende Fläche des Hohlraums bildet, und eine reflektierende Platte (48) des Resonators der Laserdiode DL am anderen Ende des erweiterten Hohlraums (82), die eine zweite reflektierende Fläche bildet,
- eine Eingangskollimationslinse (84) des Laserstrahls (Fd) in dem Hohlraum;
- eine Etalonplatte (86) zum Auswählen einer Resonanzmode in dem erweiterten Hohlraum;
- eine Katzenaugen-Ausgangslinse (90), die den Laserstrahl auf den Spiegel (92) des Hohlraums fokussiert, und
- die optische Vorrichtung (94) zwischen der Eingangskollimationslinse (84) und der Etalonplatte (86) (Modenauswahlfilter).

5. Laserquelle mit externem Resonator nach Anspruch 1 oder 4, **dadurch gekennzeichnet, dass** der Rotationswinkel ($\theta_1$) der Polarisation des Strahls (Frt) am Rotatorausgang (102) sowie der Winkel der Transmissionsachse (-$\theta_1$) des Polarisationsseparators (104) in Abhängigkeit von den gewünschten Intensitäten der transmittierten It und reflektierten Ir Strahlen von dem Polarisationsseparator (104) bestimmt werden, wobei diese Intensitäten definiert werden durch:

$$It = \cos^2(2.\theta_1)$$

$$Ir = \sin^2(2.\theta_1)$$

6. Laserquelle mit externem Resonator nach einem der Ansprüche 1 bis 5, **dadurch gekennzeichnet, dass** als Wert des Rotationswinkels ($\theta_1$) der Polarisation des Strahls (Frt) am Ausgang des Polarisationsrotators (102) +28 Grad gewählt wird, wobei die Transmissionsachse (tt') des Polarisationsseparators (104) in diesem Fall mit -28 Grad und die Reflexionsachse (rr') mit 90-$\theta_1$, das heißt mit +62 Grad ausgerichtet ist.

**7.** Laserquelle mit externem Resonator nach einem der Ansprüche 1 bis 6, **dadurch gekennzeichnet, dass** der Rotator (102) ein Faraday-Rotator ist.

**8.** Laserquelle mit externem Resonator nach einem der Ansprüche 1 bis 7, **dadurch gekennzeichnet, dass** das Modenauswahlfilter (86) ein Interferenzfilter ist.

**9.** Laserquelle mit externem Resonator nach einem der Ansprüche 1 to 8, **dadurch gekennzeichnet, dass** sie ein piezoelektrisches Füllstück (120) zum Modulieren der Position des Spiegels (92) im erweiterten Hohlraum aufweist, der von einem massiven Würfel oder Zylinder mit einer reflektierenden Fläche gebildet ist.

**10.** Laserquelle mit externem Resonator nach Anspruch 9, **dadurch gekennzeichnet, dass** die als Spiegel (92) dienende reflektierende Fläche durch Metallisieren von einer der Flächen des piezoelektrischen Füllstücks erzeugt wird, die zum Reflektieren des Laserstrahls in dem Hohlraum bestimmt ist.

FIG.1a

FIG.1b

FIG.2

Fu

SI

Fretour

80    82    94    Fretour    Frt    82    92    120

48    Fd    Pp    Fc1         Ftr    Ftrc
X                                                    X'
DL                                                   90
84    Ftrf0    100    102    104    86
              (Cube 1)         (Cube 2)

**FIG.3**

$\theta_0$                    $\theta_1$                    t'    $-\theta_1$    $(90-\theta_1)$    r'
Pfd                           Pfrt              T                              Pfu
                                                                              R
                                                                        r
                                                                        t

**FIG.4a**

$\theta_0$                    $-\theta_1$
                              Pftrc
              Pftrc0

**FIG.4b**

FIG.5a

FIG.5b

**EP 2 143 181 B1**

## RÉFÉRENCES CITÉES DANS LA DESCRIPTION

### Documents brevets cités dans la description

- EP 1172906 A